# EUROPÄISCHE PATENTANMELDUNG

(11) **EP 3 667 820 A1**
(43) Veröffentlichungstag der Anmeldung: **17.06.2020**
(21) Anmeldenummer: 19203831.3
(22) Anmeldetag: 17.10.2019
(51) Int. Cl.: H01Q 17/00, H05K 9/00, C09D 5/30, B05D 1/12, B05D 5/00, C09D 5/32, F41H 3/00, B29C 64/00

(54) **VERFAHREN ZUM HERSTELLEN EINER SCHICHT EINER VORRICHTUNG ZUR ABSORPTION VON ELEKTROMAGNETISCHER STRAHLUNG**

(30) Priorität: 14.12.2018 DE 102018132217
(71) Anmelder: Airbus Defence and Space GmbH, 82024 Taufkirchen (DE)
(72) Erfinder: KARCH, Christian, 82024 Taufkirchen (DE); METZNER, Christian, 82024 Taufkirchen (DE); BLECKMANN, Matthias, 84172 Buch am Erlbach (DE); DINNEBIER, Heinrich, 84030 Landshut (DE)
(74) Vertreter: LKGLOBAL Lorenz & Kopf PartG mbB Patentanwälte

(57) **Zusammenfassung**

Die Erfindung betrifft ein Verfahren zum Herstellen einer Schicht einer Vorrichtung zur Absorption von elektromagnetischer Strahlung, wobei das Verfahren (100) die folgenden Schritte aufweist: Bereitstellen (102) einer Lage Pulvermaterial in der herzustellenden Schicht der Vorrichtung zur Absorption von elektromagnetischer Strahlung; Bereitstellen (104) einer vordefinierten Konzentrations-Verteilung von Partikeln zur Absorption von elektromagnetischer Strahlung in der Schicht der Vorrichtung zur Absorption von elektromagnetischer Strahlung; Bereitstellen (106) eines ersten Bindemittels für das Pulvermaterial und eines zweiten Bindemittels für das Pulvermaterial, wobei das erste Bindemittel Partikel zur Absorption von elektromagnetischer Strahlung umfasst, wobei das zweite Bindemittel eine geringere Konzentration von gleichen und/oder unterschiedlichen Partikeln zur Absorption von elektromagnetischer Strahlung als das erste Bindemittel umfasst; Bestimmen (108) eines Mischungsverhältnisses zwischen dem ersten Bindemittel und dem zweiten Bindemittel für jede Position in der Schicht auf Basis der vordefinierten Konzentrations-Verteilung; Auswählen (110) einer Position der Schicht; Mischen (112) des ersten und zweiten Bindemittels gemäß dem Mischungsverhältnis für die ausgewählte Position; Benetzen (114) des Pulvermaterials an der ausgewählten Position mit dem gemischten ersten und zweiten Bindemittel; und Wiederholen (116) der Schritte Auswählen (110), Mischen (112) und Benetzen (114) zum Herstellen einer Schicht der Vorrichtung zur Absorption von elektromagnetischer Strahlung. Aufgrund der individuellen Mischung der beiden Bindemittel für jede ausgewählte Position, an der das Pulvermaterial mit dem Bindemittel verklebt werden soll, kann in jeder Raumrichtung innerhalb des herzustellenden Körpers der Vorrichtung zur Absorption von elektromagnetischer Strahlung ein Gradient in der Dielektrizitätskonstante und/oder der Permeabilität hergestellt werden. Weiter können mit dem Verfahren zur Herstellung einer Schicht der Vorrichtung zur Absorption von elektromagnetischer Strahlung ebenso auf einfache Weise elektromagnetisch wirksame Strukturen für die Vorrichtung zur Absorption von elektromagnetischer Strahlung hergestellt werden.

## Beschreibung

Die Erfindung betrifft ein Verfahren zum Herstellen einer Schicht einer Vorrichtung zur Absorption von elektromagnetischer Strahlung. Weiter betrifft die Erfindung eine Vorrichtung zur Absorption von elektromagnetischer Strahlung und ein Fortbewegungsmittel.

Zur Entdeckung und Positionserkennung von Fortbewegungsmitteln, wie zum Beispiel Schiffen oder Luft- und Raumfahrzeugen, werden zum Beispiel Radarsysteme genutzt. Die von dem Radarsystem ausgesandten Radiowellen werden von der Oberfläche der Fortbewegungsmittel reflektiert und von dem Radarsystem aufgefangen. Damit kann das Vorhandensein und die Position des Fortbewegungsmittels ermittelt werden.

Um die Reflexion von Radarwellen an den Oberflächen der Fortbewegungsmittel zu verringern, kann der Rückstreukoeffizient der Oberflächen durch Radar absorbierende Materialien oder Radar absorbierende Strukturen verringert werden. Bei Radar absorbierenden Materialien werden diese Materialien an und/oder in die äußeren Strukturen der Fortbewegungsmittel angeordnet bzw. integriert, die in der Regel entweder aus Metalllegierungen oder aus Kohlefaserverbundwerkstoffen hergestellt sind. Bei Radar absorbierenden Strukturen werden die Materialien, die für die äußeren Strukturen verwendet werden, so modifiziert, dass sie Radar absorbierende Eigenschaften erlangen. Dabei können zum Beispiel Schichtstrukturen oder Materialien mit Gradienten in der Dielektrizitätskonstante als auch der Permeabilität benutzt werden.

Aus US 2016/0263823 A1 ist bekannt, aus zwei geschmolzenen thermoplastischen Materialien Materialschichten in Form eines Rasters aufzutragen. Die beiden Materialien weisen unterschiedliche Radar absorbierende Eigenschaften auf, sodass durch die Mischung während des Auftragens ein Gradient in den Radar absorbierenden Eigenschaften hergestellt werden kann.

Aufgabe der vorliegenden Erfindung ist es daher, eine verbesserte Vorrichtung zum Absorbieren von elektromagnetischer Strahlung sowie ein verbessertes Verfahren zum Herstellen einer Schicht einer Vorrichtung zum Absorbieren von elektromagnetischer Strahlung bereitzustellen.

Die Aufgabe wird gelöst durch die Merkmale der unabhängigen Ansprüche. Vorteilhafte Weiterbildungen sind Gegenstand der abhängigen Ansprüche sowie der folgenden Beschreibung.

Gemäß einem Aspekt der Erfindung ist ein Verfahren zum Herstellen einer Schicht einer Vorrichtung zur Absorption von elektromagnetischer Strahlung vorgesehen, wobei das Verfahren die folgenden Schritte aufweist: Bereitstellen einer Lage Pulvermaterials in der herzustellenden Schicht der Vorrichtung zur Absorption von elektromagnetischer Strahlung; Bereitstellen einer vordefinierten Konzentrations-Verteilung von Partikeln zur Absorption von elektromagnetischer Strahlung in der Schicht der Vorrichtung zur Absorption von elektromagnetischer Strahlung; Bereitstellen eines ersten Bindemittels für das Pulvermaterial und eines zweiten Bindemittels für das Pulvermaterial, wobei das erste Bindemittel Partikel zur Absorption von elektromagnetischer Strahlung umfasst, wobei das zweite Bindemittel eine geringere Konzentration von gleichen und/oder unterschiedlichen Partikeln zur Absorption von elektromagnetischer Strahlung als das erste Bindemittel umfasst; Bestimmen eines Mischungsverhältnisses zwischen dem ersten Bindemittel und dem zweiten Bindemittel für jede Position in der Schicht auf Basis der vordefinierten Konzentrations-Verteilung; Auswählen einer Position der Schicht; Mischen des ersten und zweiten Bindemittels gemäß dem Mischungsverhältnis für die ausgewählte Position; Benetzen des Pulvermaterials an der ausgewählten Position mit dem gemischten ersten und zweiten Bindemittel; und Wiederholen der Schritte Auswählen, Mischen und Benetzen zum Herstellen einer Schicht der Vorrichtung zur Absorption von elektromagnetischer Strahlung.

Mit der Erfindung wird ein Verfahren bereitgestellt, mit dem die Absorption von elektromagnetischer Strahlung in einem Material einer Schicht einer Vorrichtung zur Absorption von elektromagnetischer Strahlung optimiert werden kann, wobei die Konzentration der Partikel zur Absorption der elektromagnetischen Strahlung punktuell für jede Position optimiert hergestellt wird. Die einzelnen Teilchen des Pulvermaterials werden dabei mit dem Bindemittelgemisch aus dem ersten und zweiten Bindemittel miteinander verklebt und bilden dadurch einen festen Körper. Durch das Mischen des ersten und zweiten Bindemittels, die unterschiedliche Partikelkonzentrationen von Partikeln zum Absorbieren von elektromagnetischer Strahlung aufweisen, wird eine vordefinierte Partikelkonzentration in dem Bindemittelgemisch hergestellt. Dieses Gemisch kann punktuell und mit einer sich kontinuierlich ändernden Partikelkonzentration bereitgestellt werden. Weiter kann das Bindemittelgemisch auch lediglich das erste Bindemittel oder auch lediglich das zweite Bindemittel umfassen. Die untere Grenze der Partikelkonzentration des Bindemittelgemisches ist gleich der Partikelkonzentration in dem zweiten Bindemittel. Die obere Grenze der Partikelkonzentration im Gemisch ist die Partikelkonzentration des ersten Bindemittels. Aufgrund der individuellen Mischung der beiden Bindemittel für jede ausgewählte Position, an der das Pulvermaterial mit dem Bindemittel verklebt werden soll, kann in jeder Raumrichtung innerhalb der herzustellenden Vorrichtung zur Absorption von elektromagnetischer Strahlung ein Gradient in der Dielektrizitätskonstante und/oder der Permeabilität hergestellt werden. Weiter können mit dem Verfahren zur Herstellung einer Schicht der Vorrichtung zur Absorption von elektromagnetischer Strahlung ebenso auf einfache Weise elektromagnetisch wirksame Strukturen für die Vorrichtung zur Absorption von elektromagnetischer Strahlung hergestellt werden.

Weiter kann durch das Vorsehen von unterschiedlichen Partikeln zur Absorption elektromagnetischer Strahlung die Verteilung der Partikel in dem Bindemittel und dementsprechend in der herzustellenden Struktur der Schicht der Vorrichtung zur Absorption von elektromagnetischer Strahlung optimiert werden. Dies kann zum Beispiel durch die Wahl von einander abstoßenden unterschiedlichen Partikeln zur Absorption elektromagnetischer Strahlung bewirkt werden. Durch die Abstoßungskräfte zwischen den unterschiedlichen Partikeln werden die Partikel in dem Bindemittel und in dem Bindemittelgemisch automatisch homogen verteilt.

Durch die Erfindung wird weiter eine Schicht für eine Vorrichtung zur Absorption von elektromagnetischer Strahlung bereitgestellt, die Strukturen aufweisen kann, die eine Absorption von elektromagnetischer Strahlung bewirken. Die Materialparameter können dabei mittels der Wahl der Partikelkonzentration der Partikel zur Absorption von elektromagnetischer Strahlung auf der Mikroskala beeinflusst werden. Auf der Mesoskala können die Materialien durch die Wahl der unterschiedlichen Partikel und durch die Wahl der Pulvermaterialien und Bindemittel beeinflusst werden. Eine Beeinflussung auf der Makroskala kann mittels Strukturen bewirkt werden, die mittels dem Verfahren in der Schicht zur Absorption der elektromagnetischen Strahlung hergestellt werden.

Das Verfahren zur Herstellung einer Schicht der Vorrichtung zur Absorption kann in einem Beispiel als 3D-Tintenstrahl-Pulverdruck ausgebildet sein.

Gemäß einem weiteren Beispiel weist das zweite Bindemittel keine Partikel zur Absorption von elektromagnetischer Strahlung auf.

Damit kann das Bindemittelgemisch eine Partikelkonzentration von Partikeln zur Absorption von elektromagnetischer Strahlung zwischen der Partikelkonzentration des ersten Bindemittels und einer Konzentration von null aufweisen. Auf diese Weise kann die gesamte Schicht einer Vorrichtung zur Absorption von elektromagnetischer Strahlung hergestellt werden, auch wenn keine Partikel zur Absorption von elektromagnetischer Strahlung in Teilen der Schicht vorgesehen sind. Dies erhöht die Flexibilität des Verfahrens.

Weiter können die Partikel zur Absorption von elektromagnetischer Strahlung, dielektrische, magnetische und/oder elektrisch leitende Partikel umfassen.

Die derart ausgestalteten Partikel zur Absorption von elektromagnetischer Strahlung weisen damit optimierte Eigenschaften zur Absorption von elektromagnetischer Strahlung auf.

In einem weiteren Beispiel können die Partikel allein oder in Kombination miteinander die elektromagnetische Strahlung im Megahertz, Gigahertz und/oder Terahertzbereich absorbieren.

In den Bereichen, in denen die Frequenzen im Megahertz, Gigahertz und/oder Terahertzbereich der elektromagnetischen Strahlung liegen, kann eine Entdeckung und Positionsbestimmung durch Radarsysteme erfolgen. Partikel, die einzeln, d.h. allein, in diesen Bereichen elektromagnetische Strahlung absorbieren, erleichtern die Herstellung der Schicht der Vorrichtung zur Absorption von elektromagnetischer Strahlung. Weiter können durch die Kombination von Artikeln zur Absorption von elektromagnetischer Strahlung kombinierte Partikel entstehen, die in anderen Frequenzbereichen der elektromagnetischen Strahlung eine Absorption bewirken. Eine Kombination der Partikel kann zum Beispiel durch eine Veränderung der Konzentration der unterschiedlichen Partikel des zweiten Bindemittels bewirkt werden. Auf diese Weise kann eine heterogene Schicht hergestellt werden, die in verschiedenen Regionen der Schicht je nach Topologie und Struktur der eingebetteten Partikel elektromagnetische Strahlung im gleichen oder anderen Frequenzbereichen absorbiert.

Das Pulvermaterial kann gemäß eines Beispiels homogen sein.

Die Teilchen des Pulvermaterials sind damit alle gleich ausgestaltet, so dass die hergestellte Schicht der Vorrichtung zur Absorption von elektromagnetischer Strahlung lediglich das Bindemittelgemisch und die Teilchen des Pulvermaterials aufweist. Damit kann ein homogenes Grundmaterial für die Schicht der Vorrichtung zur Absorption von elektromagnetischer Strahlung bereitgestellt werden.

In einem anderen Beispiel kann das Pulvermaterial ein Gemisch aus mindestens zwei verschiedenen Pulvermaterialien sein.

Auf diese Weise können Mischmaterialien hergestellt werden, um gegebenenfalls spezielle strukturelle Komponenten oder chemische Eigenschaften in der Schicht der Vorrichtung zur Absorption von elektromagnetischer Strahlung zu verwirklichen.

Weiter kann das Pulvermaterial ein Keramikmaterial aufweisen.

Auf diese Weise können Keramikmaterialien hergestellt werden, die elektromagnetische Strahlung absorbieren. Damit können vor allem im Hochtemperaturbereich Materialien genutzt werden, die absorbierende Eigenschaften für elektromagnetische Strahlung, vor allem im Radarbereich, aufweisen. Bei Luft- und Raumfahrzeugen können auf diese Weise zum Beispiel die Düsenaggregate bzw. die Auslässe der Düsenaggregate, die eine Strahlrichtung definieren, mit Absorptionseigenschaften für elektromagnetische Strahlung ausgestattet werden.

Gemäß einem weiteren Beispiel kann das Verfahren zusätzlich den folgenden Schritt aufweisen: Wiederholen der Verfahrensschritte nach Herstellung einer Schicht zur Herstellung von mindestens einer weiteren Schicht der Vorrichtung zur Absorption von elektromagnetischer Strahlung auf der hergestellten Schicht.

Durch die Kombination von mehreren Schichten kann ein Gradient der Dielektrizitätskonstante bzw. der Permeabilität in einer Richtung außerhalb einer einzelnen Schicht bewirkt werden. Auf diese Weise kann effektiv eine optimierte mehrschichtige Vorrichtung zur Absorption von elektromagnetischer Strahlung hergestellt werden.

Weiter kann das Verfahren nach dem Herstellen aller Schichten der Vorrichtung zur Absorption von elektromagnetischer Strahlung den nachfolgenden Schritt aufweisen: Sintern der Vorrichtung zur Absorption von elektromagnetischer Strahlung.

Auf diese Weise kann ein gesamtes Keramik-Bauteil hergestellt werden, in das die Vorrichtung zur Absorption von elektromagnetischer Strahlung integriert ist.

Die ausgewählten Positionen der Schicht können gemäß einem Beispiel ein Strukturmuster bilden, das Poren aufweist.

Mittels der Strukturmuster können absorbierende Strukturen für elektromagnetische Strahlung hergestellt werden, die zum Beispiel Radar absorbierende Strukturen sein können. In Kombination mit den in den Schichten deponierten Partikeln zur Absorption von elektromagnetischer Strahlung, kann die Absorptionsfähigkeit der Schicht bzw. der Vorrichtung zur Absorption von elektromagnetischer Strahlung weiter optimiert werden.

Es kann weiter vorgesehen sein, dass die ausgewählten Positionen der Schicht ein Strukturmuster mit unterschiedlichen Dichteverteilungen des Pulvermaterials in Kombination mit mindestens dem ersten Bindemittel bilden.

Durch die unterschiedlichen Dichteverteilungen des Pulvermaterials und damit einhergehend mit einer unterschiedlichen Dichteverteilung des mindestens ersten Bindemittels, kann die Schicht eine Struktur erhalten, die ebenfalls eine Optimierung der Absorptionsfähigkeiten bewirkt. Die Kombination von mehreren Schichten kann dabei ein heterogenes Schichtmaterial für die Vorrichtung zur Absorption von elektromagnetischer Strahlung bereitstellen, die eine unterschiedliche Dichteverteilung in einer Richtung außerhalb einer Schicht umfasst.

Gemäß einem weiteren Beispiel kann die Lage Pulvermaterial in der herzustellenden Schicht der Vorrichtung zur Absorption von elektromagnetischer Strahlung ein Strukturmuster aufweisen.

Damit kann bereits während des Auftragens der Lage Pulvermaterial eine spätere Struktur in der Schicht der Vorrichtung vorgegeben werden. Die ausgewählten Positionen sind in diesem Beispiel in dem Strukturmuster der Lage Pulvermaterial angeordnet. Auf diese Weise kann die Herstellung der Vorrichtung zur Absorption von elektromagnetischer Strahlung beschleunigt werden, da das Entfernen von überschüssigem Pulvermaterial erleichtert wird. Weiter kann die Genauigkeit eines Strukturmusters erhöht werden, da in diesem Fall nicht das Bindemittelgemisch die Grenzen des Strukturmusters festlegt, sondern die Größe der Teilchen des Pulvermaterials.

Gemäß einem weiteren Aspekt der Erfindung ist eine Vorrichtung zum Absorbieren von elektromagnetischer Strahlung vorgesehen, wobei die Vorrichtung nach dem Verfahren gemäß der vorangegangenen Beschreibung hergestellt ist, wobei die Vorrichtung mindestens eine Schicht umfasst, wobei die Schicht ein Material aus dem mit mindestens dem ersten Bindemittel gebundenen Pulvermaterial aufweist; und wobei die Schicht eine Konzentrations-Verteilung von Partikeln zur Absorption von elektromagnetischer Strahlung gemäß der vordefinierten Konzentrations-Verteilung umfasst.

Die Erfindung stellt damit eine Vorrichtung zum Absorbieren von elektromagnetischer Strahlung bereit, die im Gegensatz zum Stand der Technik sehr fein aufgelöste Partikelkonzentrationsschwankungen und -gradienten umfasst. Zum einen kann dabei mittels der Nutzung der ersten und zweiten Bindemittel die Partikelkonzentration für sehr kleine Bereiche an den ausgewählten Positionen während der Herstellung einer Schicht eingestellt werden, wobei die Bereiche durch die flüssige Phase der Bindemittel deutlich kleiner als im Stand der Technik sein können. Weiter können ebenfalls aufgrund der kleinen Bereiche, in denen das Bindemittelgemisch aufgetragen werden kann, sehr fein aufgelöste Strukturen in dem Material hergestellt werden, die deutlich kleiner sind, als im Stand der Technik. Auf diese Weise wird eine Vorrichtung bereitgestellt, die eine deutliche Verbesserung in der Absorption von elektromagnetischer Strahlung aufweist, wobei die Absorptionseigenschaften auf bestimmte Frequenzbereiche der elektromagnetischen Strahlung durch die Partikelkonzentration in Kombination mit der fein aufgelösten Materialstruktur der Vorrichtung optimiert werden können.

Gemäß einem weiteren Aspekt der Erfindung ist ein Fortbewegungsmittel vorgesehen, wobei das Fortbewegungsmittel umfasst: eine Vorrichtung zum Absorption von elektromagnetischer Strahlung gemäß der vorangegangenen Beschreibung, und eine Außenhaut; wobei die Vorrichtung an und/oder in der Außenhaut angeordnet ist.

Die Vorteile und Wirkungen des Fortbewegungsmittels sind analog zu den Vorteilen und Wirkungen der oben beschriebenen Vorrichtung. Es wird daher in dieser Hinsicht auf die oben angegebene Beschreibung verwiesen.

Im Folgenden wird die Erfindung anhand einer beispielhaften Ausführungsform mittels der beigefügten Zeichnung beschrieben. Es zeigen:
- Figur 1a, b: schematische Darstellungen eines 3-D-Druckers, der das Verfahren zum Herstellen einer Schicht einer Vorrichtung zur Absorption von elektromagnetischer Strahlung durchführt;
- Figur 2a-c: schematische Darstellungen von möglichen Strukturen der hergestellten Vorrichtung zum Absorbieren von elektromagnetischer Strahlung in verschiedenen Größenskalen;
- Figur 3a, b: schematische Darstellungen von Vorrichtungen zum Absorbieren von elektromagnetischer Strahlung;
- Figur 4a-c: schematische Darstellungen von Fortbewegungsmitteln, die die Vorrichtung zum Absorbieren von elektromagnetischer Strahlung umfassen; und
- Figur 5: ein Flussdiagramm eines Beispiels des Verfahrens zur Herstellung einer Schicht einer Vorrichtung zum Absorbieren von elektromagnetischer Strahlung.

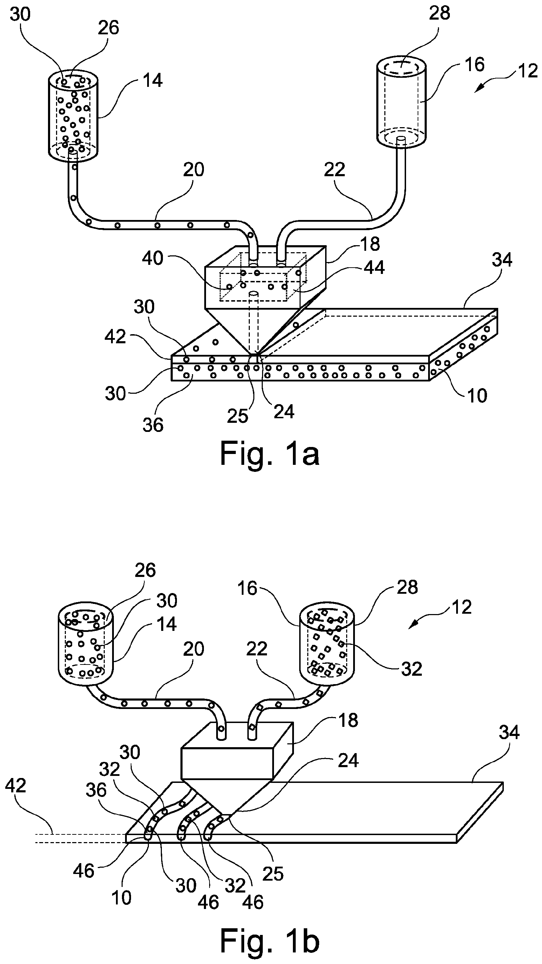

Die Vorrichtung zur Absorption von elektromagnetischer Strahlung wird in ihrer Gesamtheit mit dem Bezugszeichen 10 bezeichnet, wie beispielsweise in Figur 1a dargestellt.

Die Vorrichtung 10 umfasst mindestens eine Schicht 42, die ein Material 36 aufweist, das aus einem Pulvermaterial 34 hergestellt wurde, das mit mindestens einem ersten Bindemittel 26 gebunden wurde. Das erste Bindemittel 26 umfasst dabei Partikel 30 zur Absorption von elektromagnetischer Strahlung. Das erste Bindemittel 26 bindet die Teilchen des Pulvermaterials 34, sodass das Material 36 entsteht, das die Partikel 30 zur Absorption von elektromagnetischer Strahlung umfasst.

Das Material 36 kann dabei weiter ein zweites Bindemittel 28 aufweisen das eine geringere Konzentration von Partikeln 30 zur Absorption von elektromagnetischer Strahlung als das erste Bindemittel 26 aufweist. Das zweite Bindemittel 28 kann dabei keine Partikel 30 zur Absorption von elektromagnetischer Strahlung aufweisen. In einem alternativen Ausführungsbeispiel des zweiten Bindemittels 28, kann das Bindemittel 28 alternativ oder zusätzlich zu den Partikeln 30 zur Absorption von elektromagnetischer Strahlung zu den Partikeln 30 unterschiedliche Partikel 32 zur Absorption von elektromagnetischer Strahlung aufweisen. Diese sich von den Partikeln 30 unterscheidenden Partikel 32 können eine Abstoßungseigenschaft mit den Partikeln 30 aufweisen, sodass sich die Partikel 32 und die Partikel 30 gegenseitig abstoßen. Auf diese Weise kann eine homogene Verteilung der Partikel 30 und der Partikel 32 erfolgen.

Die Partikel 30 zur Absorption von elektromagnetischer Strahlung können dabei dielektrische, magnetische und/oder elektrisch leitende Partikel umfassen. Weiter können die Partikel 30 allein oder in Kombination miteinander die elektromagnetische Strahlung in einem Frequenzbereich absorbieren, der im Megahertz, Gigahertz und/oder im Terahertzbereich angeordnet sein kann.

Das Material 36 kann dabei ein Gemisch aus dem ersten Bindemittel 26 und dem zweiten Bindemittel 28 umfassen. Weiter kann das Material 36 in Kombination mit dem Pulvermaterial 34 lediglich das zweite Bindemittel 28 oder lediglich das erste Bindemittel 26 umfassen.

Die Vorrichtung 10 kann dabei aus mehreren Schichten 42 hergestellt sein, wobei jede Schicht 42 eine eigene Konzentrationsverteilung für die Partikel 30 zur Absorption von elektromagnetischer Strahlung aufweist. Die Konzentration der Partikel 30 und gegebenenfalls der Partikel 32 in einer Schicht 42 kann dabei auch null sein.

Weiter kann die Konzentrationsverteilung in einer Schicht 42 eine minimale Partikelkonzentration für die Partikel 30 zur Absorption von elektromagnetischer Strahlung aufweisen, die der Konzentration der Partikel 30 in dem zweiten Bindemittel 28 entspricht. Eine maximale Partikelkonzentration der Konzentrationsverteilung in der Schicht 42 kann der Konzentration der Partikel 30 in dem ersten Bindemittel 26 entsprechen.

Weiter umfasst die Vorrichtung 10 eine sehr fein aufgelöste Verteilung der Partikel 30 zur Absorption von elektromagnetischer Strahlung, die innerhalb einer Schicht 42 und zwischen verschiedenen Schichten 42 Gradienten in der Partikelkonzentration aufweisen kann. Die feine Auflösung der Partikelverteilung in der Vorrichtung 10 wird durch die Herstellung mittels des ersten Bindemittels 26 und des zweiten Bindemittels 28 in Kombination mit dem Pulvermaterial 34 bewirkt. Die ersten und zweiten Bindemittel 26 und 28 werden dabei in Reinform oder als Gemisch jeweils in Form kleiner Tröpfchen auf das Pulvermaterial 34 aufgetragen, sodass im Vergleich zum Stand der Technik sehr klein ausgebildete Bereiche des Pulvermaterials 34 durch das Bindemittel 26, 28 bzw. Bindemittelgemisch 40 benetzt werden. Damit kann in der Vorrichtung 10 eine vordefinierte Konzentrations-Verteilung sehr genau umgesetzt sein. Ebenfalls wird eine Variation der Konzentration innerhalb einer Schicht 42 in verschiedenen Richtungen sowie zwischen den Schichten 42 in einer Richtung senkrecht zur einer Schicht 42 ermöglicht.

Die Herstellung des Material 36 der Vorrichtung 10 kann mittels eines 3-D Druckers 12 erfolgen. Der 3-D Drucker 12 umfasst dabei einen ersten Tank 14, in dem das erste Bindemittel 26 gelagert ist. Weiter umfasst der 3-D Drucker 12 einem zweiten Tank 16, in dem das zweite Bindemittel 28 gelagert ist. Die beiden Tanks 14, 16 sind über Leitungen 20, 22 mit einem Druckkopf 18 verbunden, wobei die Leitungen 20, 22 das erste Bindemittel 26 und das zweite Bindemittel 28 dem Druckkopf 18 zuführen. Der Druckkopf 18 umfasst eine Mischkammer 44, in der das erste Bindemittel 26 und das zweite Bindemittel 28 zu einem Bindemittelgemisch 40 vermischt werden können. Das Bindemittelgemisch 40 kann dabei auch lediglich aus dem ersten Bindemittel 26 bzw. lediglich aus dem zweiten Bindemittel 28 bestehen.

Weiter wird das Bindemittelgemisch 40 über eine Austrittsdüse 24 auf eine ausgewählte Position 25 einer Lage von Pulvermaterial 34 aufgetragen. Der Druckkopf 18 und das Pulvermaterial 34 können dabei eine Relativbewegung in einer Ebene, in der das Pulvermaterial 34 angeordnet ist durchführen. Weiter kann eine Relativbewegung zwischen dem Druckkopf 18 und dem Pulvermaterial 34 in einer Richtung senkrecht zu der Ebene erfolgen, wenn eine Schicht 42 fertiggestellt wurde und eine neue Lage Pulvermaterial 34 über der fertiggestellten Schicht 42 abgelegt werden soll.

Das Pulvermaterial 34 kann dabei ein Kunststoffmaterial, eine Metalllegierung oder ein Keramikmaterial sein. Im Beispiel des Keramikmaterials kann die Vorrichtung 10 beispielsweise sehr hohen Temperaturen ausgesetzt werden, bei denen Kunststoffe oder Metalllegierungen beschädigt werden würden.

In Figur 1b ist ein alternatives oder zusätzliches Beispiel der Vorrichtung 10 dargestellt. Die Schicht 42 der Vorrichtung 10 umfasst dabei mehrere Strukturelemente 46, die voneinander getrennt in der Lage des Pulvermaterials 34 durch das Benetzen mit dem Bindemittelgemisch 40 hergestellt werden. Die Verbindung der einzelnen in der Schicht 42 voneinander getrennten Strukturelemente 46 kann beispielsweise durch die Herstellung einer weiteren Schicht der Vorrichtung 10 zur Absorption von elektromagnetischer Strahlung oberhalb der Strukturelemente 46 erfolgen, wobei in der weiteren Schicht Strukturelemente hergestellt werden, die sich zum Beispiel quer zu den Strukturelementen 46 der bereits hergestellten Schicht 42 erstrecken. Ebenso kann bereits mit einer unterhalb liegenden Schicht eine Verbindung der Strukturelemente 46 erfolgt sein.

Weiter ist in Figur 1b ein zweites Bindemittel 28 dargestellt, dass keine Partikel 30 zur Absorption elektromagnetischer Strahlung aufweist. Stattdessen weist das zweite Bindemittel 28 in dem Beispiel aus Figur 1b Partikel 32 auf, die sich von den Partikeln 30 unterscheiden. Damit seien jedoch keine Beispiele ausgeschlossen, in denen das zweite Bindemittel 28 zusätzlich Partikel 30 zur Absorption von elektromagnetischer Strahlung aufweist.

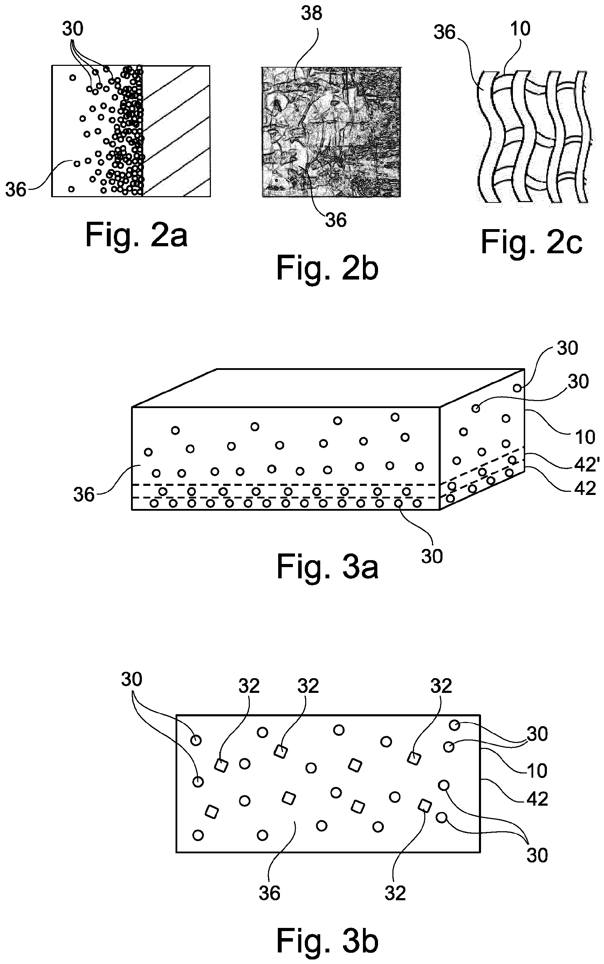

Die Figuren 2a, 2b und 2c zeigen verschiedene Größenskalen des hergestellten Materials 36.

Figur 2a zeigt das Material 36 dabei eine Mikroskala, in der die Partikel 30 zur Absorption von elektromagnetischer Strahlung dargestellt sind. Die Partikel 30 sind dabei in den durch das Bindemittelgemisch 40 verbundenen Teilchen des Pulvermaterials 34 eingebettet. Von links nach rechts nimmt dabei die Konzentration der Partikel 30 zur Absorption von elektromagnetischer Strahlung zu. An der linken Bildseite von Figur 2a sind keine Partikel 30 vorhanden, d.h. die Konzentration der Partikel 30 beträgt hier null. Auf der rechten Seite der Figur 2a ist die Konzentration der Partikel 30 maximal. Dazwischen findet ein kontinuierlicher Übergang der Partikelkonzentration von null zur maximalen Partikelkonzentration statt.

In Figur 2b ist eine Mesoskala des Materials 36, bei der die Partikel 30 zur Absorption von elektromagnetischer Strahlung nicht mehr zu sehen sind. Stattdessen ist die übergeordnete Struktur des Materials 36 auf mikroskopischer Ebene dargestellt. Diese mikroskopische Struktur kann durch die Wahl der Bindemittel 26, 28, der Wahl des Pulvermaterials 34 sowie der Wahl der Partikel 30 und gegebenenfalls der Partikel 32 beeinflusst werden. Dabei kann die mikroskopische Struktur des Materials 36 einen Beitrag bei der Absorption von elektromagnetischer Strahlung leisten. So kann das Material 36 in der Mesoskale z. B. kristalline Strukturen 38 aufweisen.

Weiter kann die mikroskopische Struktur innerhalb einer Schicht 42 und zwischen den Schichten 42 variiert werden. So können zum Beispiel durch die geeignete Wahl der Materialien Poren der mikroskopischen Struktur des Materials 36 entstehen. Diese Poren haben ebenfalls einen Einfluss auf die Absorptionseigenschaften für elektromagnetische Strahlung.

Figur 2c zeigt eine Makroskala des Materials 36, bei der sichtbare Strukturelemente 46 der Vorrichtung 10 dargestellt sind. Durch die Anordnung der Strukturelemente 46, die in diesem Beispiel eine Gitterstruktur darstellt, kann zum Beispiel durch Absorptions-, Beugungs- und/oder Interferenzeffekte elektromagnetische Strahlung beeinflusst werden.

Die Strukturelemente 46 weisen in der Figur 2c von links nach rechts eine abnehmende Dicke und einen zunehmenden Abstand voneinander auf. Auf diese Weise kann ebenfalls mittels der Strukturelemente 46 ein Gradient in den Absorptionseigenschaften für elektromagnetische Strahlung bereitgestellt werden.

Figur 3a zeigt eine fertig hergestellte Vorrichtung 10, die in einem Beispiel auf einem nicht dargestellten Substrat angeordnet und mit ihm verbunden sein kann. Das Substrat kann dabei zum Beispiel ein Bauteil sein, das mit der Vorrichtung 10 ausgestattet wird, um eine Reflexion von elektromagnetischer Strahlung, die auf das Bauteil trifft, zu verhindern.

Die Vorrichtung 10 weist dabei in einer Schicht 42 eine vordefinierte Konzentrationsverteilung für die Partikel 30 zur Absorption von elektromagnetischer Strahlung auf. In einer weiteren Schicht 42' weist die Vorrichtung 10 eine andere vordefinierte Konzentrationsverteilung für die Partikel 30 zur Absorption von elektromagnetischer Strahlung auf. Durch die Anordnung der Schichten 42, 42' zueinander, kann elektromagnetische Strahlung, die durch das Material 36 der Vorrichtung 10 propagiert an verschiedenen Positionen in der Vorrichtung 10 verschieden beeinflusst werden. Wenn zum Beispiel elektromagnetische Strahlung von oben auf die Vorrichtung 10 in der Figur 3a trifft, kann zum Beispiel zunächst keine Beeinflussung stattfinden bis die elektromagnetische Strahlung innerhalb der Vorrichtung 10 ist. Dabei kann auf dem Weg durch die Vorrichtung 10 von oben nach unten die elektromagnetische Strahlung immer stärker beeinflusst werden, was durch die Verteilung der Partikel 30 in der Vorrichtung 10 bewirkt wird.

Auf diese Weise können Reflexionen durch einen plötzlichen Übergang von keiner Beeinflussung der elektromagnetischen Strahlung zu einer starken Beeinflussung der elektromagnetischen Strahlung vermieden werden.

Figur 3b zeigt eine Partikel verteilung in einer Schicht 42 einer Vorrichtung 10. Die Schicht 42 umfasst dabei Partikel 30 zur Absorption von elektromagnetischer Strahlung sowie sich von den Partikeln 30 unterscheidende Partikel 32. Die Partikel 32 und die Partikel 30 stoßen sich gegenseitig ab. Bei der Herstellung der Schicht 42 wurden daher beim Mischen der Partikel 32 mit den Partikeln 30 im Bindemittelgemisch 40 eine homogene Verteilung der Partikel 30 in dem Bindemittelgemisch 40 bewirkt. Dies homogene Verteilung der Partikel 30 wurde durch das Auftragen des Bindemittelgemisches 40 auf das Pulvermaterial 34 in das herzustellende Material 36 übertragen.

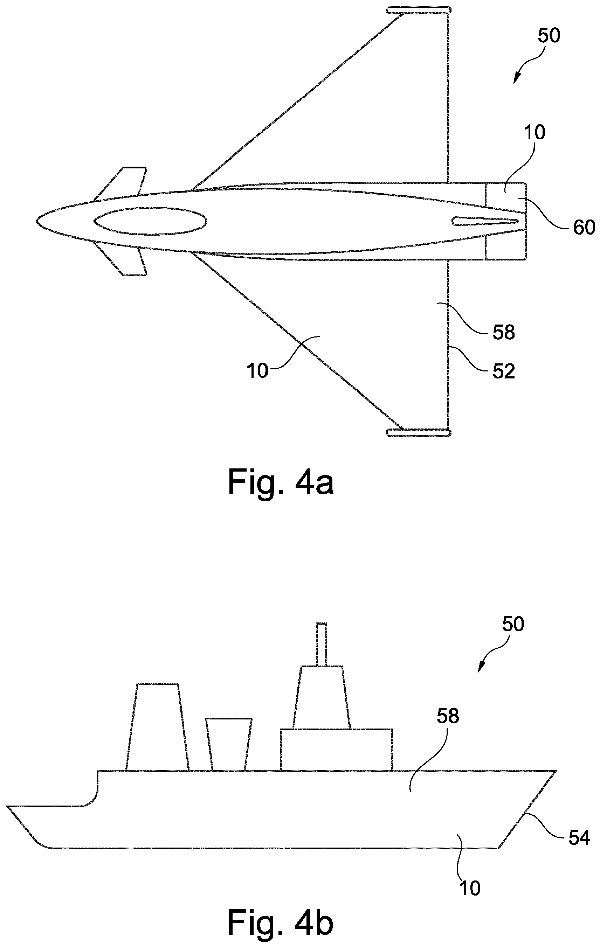

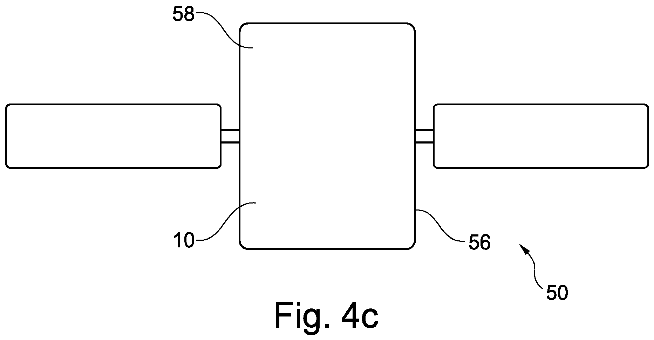

Die Figuren 4a, 4b und 4c stellen verschiedene Fortbewegungsmittel 50 dar, die eine Vorrichtung 10 zur Absorption von elektromagnetischer Strahlung aufweisen.

In Figur 4a ist dabei ein Flugzeug 52 dargestellt, das eine Außenhaut 58 aufweist. Die Außenhaut 58 umfasst dabei eine Vorrichtung 10 zur Absorption von elektromagnetischer Strahlung. Die Vorrichtung 10 kann dabei auf der Außenhaut 48 angeordnet sein und mit der Außenhaut 48 verbunden worden sein. Alternativ oder zusätzlich kann die Vorrichtung 10 in die Außenhaut 48 integriert sein, d.h., dass die Vorrichtung 10 einen Teil der Außenhaut 48 über die gesamte Außenhaut 48 bildet.

Weiter kann die Vorrichtung 10 zum Beispiel an einem Triebwerksauslass 60 angeordnet sein, wenn die Vorrichtung 10 ein Material 34 aufweist, das ein keramisches Material aufweist, das bei hohen Temperaturen keinen Schaden nimmt.

Figur 4b stellt ein Schiff 54 dar. Das Schiff 54 weist eine Außenhaut 58 auf, die in Figur 4b an einer Seitenwand angeordnet sein kann. Die Außenhaut 58 umfasst die Vorrichtung 10, wobei analoges zu der Beschreibung der Figur 4a gilt.

Gleiches gilt für das Fortbewegungsmittel 50 der Figur 4c, das ein Raumfahrzeug 56 darstellt, das eine Außenhaut 58 umfasst, an der die Vorrichtung 10 angeordnet ist.

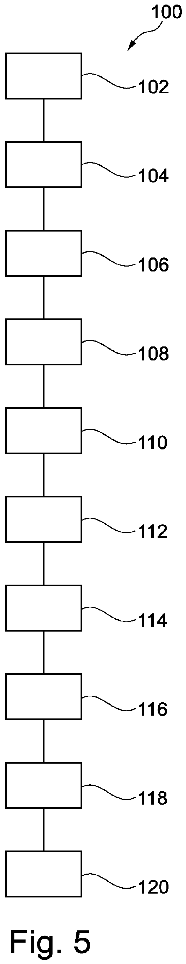

Figur 5 zeigt ein Flussdiagramm für das Verfahren 100 zur Herstellung einer Schicht einer Vorrichtung zur Absorption von elektromagnetischer Strahlung.

In einem Schritt 102 stellt das Verfahren 100 eine Lage Pulvermaterial bereit, die in der herzustellenden Schicht der Vorrichtung zur Absorption von elektromagnetischer Strahlung angeordnet ist. Die Lage Pulvermaterial kann in der herzustellenden Schicht der Vorrichtung zur Absorption von elektromagnetischer Strahlung ein Strukturmuster aufweisen. Das Pulvermaterial kann damit bereits vor dem Auftragen von Bindemittel ein Strukturmuster für die herzustellende Schicht der Vorrichtung festlegen.

Weiter wird in einem Schritt 104 eine vordefinierte Konzentrations-Verteilung von Partikeln zur Absorption von elektromagnetischer Strahlung in der Schicht der Vorrichtung zur Absorption von elektromagnetischer Strahlung bereitgestellt. Diese Konzentrations-Verteilung ist dabei so ausgebildet, dass in Kombination mit weiteren herzustellenden Schichten der Vorrichtung zur Absorption von elektromagnetischer Strahlung die elektromagnetische Strahlung optimal absorbiert wird und eine Reflexion der elektromagnetischen Strahlung an der Vorrichtung vermieden wird. Die Konzentrations-Verteilung kann dabei Gradienten der Verteilung der Partikel zur Absorption von elektromagnetischer Strahlung aufweisen.

In einem Schritt 106 werden ein erstes Bindemittel für das Pulvermaterial und ein zweites Bindemittel für das Pulvermaterial bereitgestellt. Dabei umfasst das erste Bindemittel Partikel zur Absorption von elektromagnetischer Strahlung. Das zweite Bindemittel umfasst eine geringere Konzentration der Partikel zur Absorption von elektromagnetischer Strahlung als das erste Bindemittel. Weiter kann das zweite Bindemittel alternativ oder zusätzlich unterschiedliche Partikel zu den Partikeln zur Absorption von elektromagnetischer Strahlung aufweisen. Die sich von den Partikeln zur Absorption von elektromagnetischer Strahlung unterscheidenden Partikel können ebenfalls Partikel sein, die elektromagnetische Strahlung absorbieren. Dabei können die Partikel und die sich davon unterscheidenden Partikel die elektrische, magnetische und/oder elektrisch leitende Partikel umfassen. Weiter können die Partikel zur Absorption von elektromagnetischer Strahlung sowie die sich davon unterscheidenden Partikel allein oder in Kombination miteinander Frequenzbereiche absorbieren, die im Megahertz, Gigahertz und/oder Terahertz-Bereich angeordnet sind.

Die Schritte 102, 104 und 106 können in beliebiger Reihenfolge durchgeführt werden.

Das Verfahren 100 weist in einem Schritt 108 das Bestimmen eines Mischungsverhältnisses zwischen dem ersten Bindemittel und dem zweiten Bindemittel für jede Position in der Schicht auf Basis der vordefinierten Konzentrationsverteilung auf. Das Mischungsverhältnis des ersten und zweiten Bindemittels basiert dabei auf der Anzahl der Partikel zur Absorption der elektromagnetischen Strahlung, die in dem gemischten Bindemittel vorhanden sein müssen, um eine Absorption der elektromagnetischen Strahlung zu bewirken, die der vordefinierten Konzentrationsverteilung an der ausgewählten Position entspricht. Dies wird für jede Position der Schicht durchgeführt.

In einem weiteren Schritt 110 wird eine Position der Schicht ausgewählt. Um Strukturelemente der Vorrichtung herzustellen, können Positionen der Schicht definiert werden, die nicht ausgewählt werden und auf denen damit kein Bindemittelgemisch aufgetragen wird. Weiter kann mit dem Auswählen der Positionen der Schicht die Struktur der Vorrichtung auf makroskopischer Ebene definiert werden.

Für die ausgewählte Position wird gemäß einem Schritt 112 das erste Bindemittel gemäß dem Mischungsverhältnis mit dem zweiten Bindemittel gemischt. Das Mischungsverhältnis kann dabei auch vorsehen, dass das erste Bindemittel oder das zweite Bindemittel in Reinform bereitgestellt werden sollen.

Das gemischte Bindemittel wird in einem Schritt 114 auf das Pulvermaterial an der ausgewählten Position aufgetragen, sodass das gemischte Bindemittel das Pulvermaterial an dieser Position benetzt. Dadurch wird eine Verbindung der Teilchen des Pulvermaterials miteinander an der ausgewählten Position bewirkt. Gleichzeitig werden dabei Partikel zur Absorption von elektromagnetischer Strahlung gemäß der Konzentrations-Verteilung in das Pulvermaterial eingebracht.

Die Schritte 110,112 und 114 werden gemäß einem weiteren Schritt 116 so lange wiederholt, bis eine Schicht der Vorrichtung zur Absorption von elektromagnetischer Strahlung hergestellt wurde.

In einem weiteren Schritt 118 können die vorgenannten Verfahrensschritte 102 bis 116 für die Herstellung mehrerer Schichten der Vorrichtung zur Absorption von elektromagnetischer Strahlung wiederholt werden. Dabei wird nach der Fertigstellung einer Schicht der Vorrichtung gemäß Schritt 102 eine weitere Lage Pulvermaterial auf der hergestellten Schicht abgelegt und mit den weiteren Schritten 104 bis 116 fortgefahren. Mit den Schritten 104, 106 und 108 kann zeitgleich mit dem Schritt 102 begonnen werden.

Wenn das Pulvermaterial ein keramisches Material umfasst, kann in einem weiteren Schritt 120 nach Herstellung aller Schichten die Vorrichtung zur Absorption von elektromagnetischer Strahlung gesintert werden, um die Vorrichtung zur Absorption von elektromagnetischer Strahlung fertigzustellen und das keramische Material zu härten.

## Patentansprüche

1. Verfahren zum Herstellen einer Schicht einer Vorrichtung zur Absorption von elektromagnetischer Strahlung, wobei das Verfahren (100) die folgenden Schritte aufweist:
- Bereitstellen (102) einer Lage Pulvermaterial in der herzustellenden Schicht der Vorrichtung zur Absorption von elektromagnetischer Strahlung;
- Bereitstellen (104) einer vordefinierten Konzentrations-Verteilung von Partikeln zur Absorption von elektromagnetischer Strahlung in der Schicht der Vorrichtung zur Absorption von elektromagnetischer Strahlung;
- Bereitstellen (106) eines ersten Bindemittels für das Pulvermaterial und eines zweiten Bindemittels für das Pulvermaterial, wobei das erste Bindemittel Partikel zur Absorption von elektromagnetischer Strahlung umfasst, wobei das zweite Bindemittel eine geringere Konzentration von gleichen und/oder unterschiedlichen Partikeln zur Absorption von elektromagnetischer Strahlung als das erste Bindemittel umfasst;
- Bestimmen (108) eines Mischungsverhältnisses zwischen dem ersten Bindemittel und dem zweiten Bindemittel für jede Position in der Schicht auf Basis der vordefinierten Konzentrations-Verteilung;
- Auswählen (110) einer Position der Schicht;
- Mischen (112) des ersten und zweiten Bindemittels gemäß dem Mischungsverhältnis für die ausgewählte Position;
- Benetzen (114) des Pulvermaterials an der ausgewählten Position mit dem gemischten ersten und zweiten Bindemittel; und
- Wiederholen (116) der Schritte Auswählen (110), Mischen (112) und Benetzen (114) zum Herstellen einer Schicht der Vorrichtung zur Absorption von elektromagnetischer Strahlung.

2. Verfahren nach Anspruch 1, wobei das zweite Bindemittel keine Partikel zur Absorption von elektromagnetischer Strahlung aufweist.

3. Verfahren nach Anspruch 1 oder 2, wobei die Partikel zur Absorption von elektromagnetischer Strahlung, dielektrische, magnetische und/oder elektrisch leitende Partikel umfassen.

4. Verfahren nach einem der Ansprüche 1 bis 3, wobei die Partikel allein oder in Kombination miteinander die elektromagnetische Strahlung im Megahertz, Gigahertz und/oder Terahertzbereich absorbieren.

5. Verfahren nach einem der Ansprüche 1 bis 4, wobei das Pulvermaterial homogen ist.

6. Verfahren nach einem der Ansprüche 1 bis 4, wobei das Pulvermaterial ein Gemisch aus mindestens zwei verschiedenen Pulvermaterialien ist.

7. Verfahren nach einem der Ansprüche 1 bis 6, wobei das Pulvermaterial ein Keramikmaterial aufweist.

8. Verfahren nach einem der Ansprüche 1 bis 7, wobei das Verfahren zusätzlich den folgenden Schritt aufweist:
- Wiederholen (118) der Verfahrensschritte nach Herstellung einer Schicht zur Herstellung von mindestens einer weiteren Schicht der Vorrichtung zur Absorption von elektromagnetischer Strahlung auf der hergestellten Schicht.

9. Verfahren nach den Ansprüchen 7 und 8, wobei das Verfahren nach dem Herstellen aller Schichten der Vorrichtung zur Absorption von elektromagnetischer Strahlung den nachfolgenden Schritt aufweist:
- Sintern (120) der Vorrichtung zur Absorption von elektromagnetischer Strahlung.

10. Verfahren nach einem der Ansprüche 1 bis 9, wobei die ausgewählten Positionen der Schicht ein Strukturmuster bilden, das Poren aufweist.

11. Verfahren nach einem der Ansprüche 1 bis 10, wobei die ausgewählten Positionen der Schicht ein Strukturmuster mit unterschiedlichen Dichteverteilungen des Pulvermaterials in Kombination mit mindestens dem ersten Bindemittel bilden.

12. Verfahren nach einem der Ansprüche 1 bis 11, wobei die Lage Pulvermaterial in der herzustellenden Schicht der Vorrichtung zur Absorption von elektromagnetischer Strahlung ein Strukturmuster aufweist.

13. Vorrichtung zum Absorbieren von elektromagnetischer Strahlung, wobei die Vorrichtung (10) nach dem Verfahren (100) gemäß der vorangegangenen Ansprüche hergestellt ist, wobei die Vorrichtung (10) mindestens eine Schicht (42) umfasst,
wobei die Schicht (42) ein Material (36) aus dem mit mindestens dem ersten Bindemittel (26) gebundenen Pulvermaterial (34) aufweist; und
wobei die Schicht (42) eine Konzentrations-Verteilung von Partikeln (30) zur Absorption von elektromagnetischer Strahlung gemäß der vordefinierten Konzentrations-Verteilung umfasst.

14. Fortbewegungsmittel (50) umfassend:
eine Vorrichtung (10) zum Absorption von elektromagnetischer Strahlung nach Anspruch 13, und
eine Außenhaut (58);
wobei die Vorrichtung (10) an und/oder in der Außenhaut (58) angeordnet ist.
